(19) **Europäisches Patentamt**

**European Patent Office**

**Office européen des brevets**

(11) Veröffentlichungsnummer: **0 207 486**

**B1**

(12) **EUROPÄISCHE PATENTSCHRIFT**

(45) Veröffentlichungstag der Patentschrift: **23.05.90**

(21) Anmeldenummer: **86108896.1**

(22) Anmeldetag: **30.06.86**

(51) Int. Cl.⁵: **H 01 L 21/28, H 01 L 21/285, H 01 L 29/62**

(54) Integrierte MOS-Transistoren enthaltende Schaltung mit einer aus einem Metall oder Metallsilizid der Elemente Tantal oder Niob bestehenden Gatemetallisierung sowie Verfahren zur Herstellung dieser Gatemetallisierung.

(30) Priorität: **02.07.85 DE 3523648**

(43) Veröffentlichungstag der Anmeldung:
**07.01.87 Patentblatt 87/02**

(45) Bekanntmachung des Hinweises auf die
Patenterteilung:
**23.05.90 Patentblatt 90/21**

(84) Benannte Vertragsstaaten:
**AT DE FR GB IT NL**

(56) Entgegenhaltungen:
EP-A-0 000 317
WO-A-81/02222
US-A-4 337 476

JOURNAL OF APPLIED PHYSICS, Band 51, Nr. 3,
März 1980, Seiten 1593-1598, American Institute
of Physics, New York, US; S.P. MURARKA et al.:
"Silicide formation in thin cosputtered
(tantalum + silicon) films on polycrystalline
silicon and SiO2"

(73) Patentinhaber: **Siemens Aktiengesellschaft**
**Wittelsbacherplatz 2**
**D-8000 München 2 (DE)**

(72) Erfinder: **Hieber, Konrad, Dr.**
**Laubensteinstrasse 7**
**D-8214 Bernau (DE)**
Erfinder: **Neppl, Franz, Dr.**
**St. Quirin-Platz 6**
**D-8000 München 90 (DE)**

(56) References cited:
**IEEE TRANSACTIONS ON ELECTRON DEVICES,
Band ED-27, Nr. 8, August 1980, Seiten 1409-
1417, IEEE, New York, US; S.P. MURARKA et al.:
"Refractory silicides of titanium and tantalum
for low-resistivity gates and interconnects"
IEEE JOURNAL OF SOLID-STATE CIRCUITS,
Band SC-17, Nr. 2, April 1982, Seiten 138-141,
IEEE, New York, US; F. NEPPL et al.: "Properties
of evaporated and sputtered TaSi2 films and the
influence of the residual gas composition"**

Courier Press, Leamington Spa, England.

## Beschreibung

Integrierte MOS-Transistoren enthaltende Schaltung mit einer aus einem Metall oder Metallsilizid der Elemente Tantal oder Niob bestehenden Gatemetallisierung sowie Verfahren zur Herstellung dieser Gatemetallisierung.

Die Erfindung betrifft eine integrierte MOS-Transistoren enthaltende Schaltung mit einem aus Silizium bestehenden Halbleitersubstrat, in dem und auf dem die die Schaltung bildenden Elemente wie Source-/Drainzonen, Gateelektroden und Kontaktleitbahnen, von Isolationsschichten getrennt, in MOS-Technik erzeugt sind und bei der die über dem Gateoxid aufgebrachte Gatemetallisierung aus einem Metall bzw. Metallsilizid eines der Elemente Tantal oder Niob besteht, sowie ein Verfahren zur Herstellung der Gatemetallisierung.

In der LSI (=large scale integrated)-MOS (=metal-oxide-semiconductor)-Halbleitertechnologie wird dotiertes, polykristallines Silzium (Poly-Si) als Standardmaterial für die Gate-Kontaktierung (Gate-Metallisierung) eingesetzt. Hauptsächlicher Grund hierfür ist, daß das Poly-Si in Verbindung mit einem dünnen (zum Beispiel 20 nm) Gateoxid, vorzugsweise aus $SiO_2$ bestehend, sehr stabile und hohe reproduzierbare Grenzflächeneigenschaften besitzt (dies sind unter anderem geringe mechanische Spannungen, geringe Lechströme, hohe Durchbruchsspannung und definierte Austrittsarbeit), die wiederum direkt das elektrische Verhalten des MOS-Transistors bestimmen. Die Leitfähigkeit der Poly-Si-Schicht wird durch den Flächenwiderstand $R_F = \rho/d$ charakterisiert. Da für hochdotiertes Poly-Si ein spezifischer elektrischer Widerstand von minimal 800 µOhm cm angenommen werden kann, ergibt sich für eine 500 nm dicke Schicht ein Flächenwiderstand von 16 Ohm.

In der VLSI (=very large scale integrated)-MOS-Technologie wird die Größe der elektrischen aktiven Bereiche im Halbleitersubstrat auf Dimensionen von 1 µm und darunter reduziert, so daß auch zum Beispiel der Durchmesser von Kontaktlöchern bzw. die Breite der Leitbahnen ebenfalls in diesem Größenbereich liegen. Diese wiederum schafft die Möglichkeit, die Anzahl der Untereinheiten (zum Beispiel Speichereinheiten) pro Bauelement zu erhöhen.

Die Folge dieser Entwicklung ist, daß bei verringertem Querschnitt und erhöhter Länge der Verbindungsleitungen (aus dotiertem Poly-Si) der Bahnwiderstand stark ansteigt. Dadurch kommt es zu einer Erhöhung der R-C-Zeitkonstanten (R=Widerstand, C=Kapazität) des Bauelements, was eine entscheidende Reduzierung der Schaltgeschwindigkeiten zur Folge hat. Für DRAM (dynamische random excess memory)-Speicherbauelemente mit mehr als 256 kbit Speichereinheiten kann dies eine Erhöhung der Speicherzugriffszeit gegenüber weniger hochintegrierten Bauelementen (zum Beispiel 64 kbit DRAM) bedeuten.

Um derartige Effekte bei zum Beispiel dynamischen Speicherbauelementen mit über 1 Mega bit Speicherkapazität zu vermeiden, und um die Anforderungen bezüglich Packungsdichte erfüllen zu können, muß für die Metallisierungsschicht in der Gateebene ein Flächenwiderstand von 0,3 bis 0,6 Ohm bei einer maximalen Schichtdicke von 500 nm gefordert werden. Solche geringen Widerstandswerte sind auch mit höchst dotiertem Poly-Si nicht mehr zu erreichen. Es wird somit ein neues Material benötigt, welches eine hohe elektrische Leitfähigkeit besitzt und außerdem die Eigenschaft des sehr dünnen Gateoxids ($SiO_2$) auch bei den im Herstellprozeß notwendigen hohen Temperaturen von zum Beispiel 900°C nicht verschlechtert. Eine weitere, sehr wesentliche Forderung ist, daß das Material ohne großen Aufwand in bereits existierende Herstellprozesse für Halbleiterbauelemente leicht integrierbar ist.

Der elektrische Widerstand der Metallisierung in der Gatebene kann dadurch reduziert werden, daß das polykristalline Silizium teilweise durch eine Disilizidschicht der Metalle Molybdän, Wolfram, Tantal oder Titan ersetzt wird, wie es zum Beispiel in einem Aufsatz von S. P. Murarka in J. Vac. Sci. Technol. 17 (1980) auf den Seiten 775 bis 792 beschrieben ist. Der Materialkombination liegt der Gedanke zugrunde, daß die Disilizide der genannten Metalle auch bei Temperaturen um 1000°C nicht mehr mit Silizium reagieren. Ferner bildet diese Materialkombination in sauerstoffhaltiger Atmosphäre eine $SiO_2$-Passivierungsschicht auf dem Disilizid. Da eine dünne Poly-Si-Schicht (ca. 200 nm) zwischen dem Gateoxid und dem Disilizid verbleibt, werden auch die günstigen elektrischen Eigenschaften und die Langzeitstabilität der Poly-Si/$SiO_2$-Grenzschicht nicht negativ beeinflußt. Mit dieser Doppelschicht aus 200 nm Poly-Si und 300 nm Disilizid ist zwar eine höchste Kompatibilität mit dem bestehenden Poly-Si-Gateprozeß erreicht, jedoch sind auch mit dem niederohmigsten Disilizid (ρ von Titansilizid: 25 µOhm cm) nur Flächenwiderstände von bestenfalls 0,6 Ohm bis 0,8 Ohm erzielbar.

Verwendet man eine reine Silizidmetallisierung, das heißt, das Disilizid ist in direktem Kontakt mit dem Gateoxid, so hätte dies, aufgrund der höheren Austrittsarbeit der Silizide in Vergleich zum Poly-Si, noch zusätzliche, schaltungstechnische Vorteile. Titansilizid wäre jedoch das einzige Disilizid, mit dem der geforderte Flächenwiderstand bei 500 nm Dicke erreichbar wäre. Wie aus einem Bericht von S. P. Murarka aus dem Buch "Silicides for VLSI Applications, Academic Press, 1983, New York, Seite 30, zu entnehmen ist, liegen die spezifischen Widerstandswerte von cogesputtertem Tantaldislizid bei ca. 50 µOhm cm, von cogesputtertem Wolframdisilizid bei 70 µOhm c. Die hohe Reaktivität des Titansilizids bei 900°C (nachträgliche Prozeßtemperatur) führt jedoch zu einer Reaktion mit dem $SiO_2$, wobei $TiO_2$ als Endprodukt ensteht. Das Gateoxid wird dabei zerstört.

Aus der amerikanischen Patentschrift 4 337 476 ist bekannt, daß mit einem Überschuß an Silizium im Titandisilizid bzw. Tantaldisilizid eine stabile Gatemetallisierung möglich ist. Jedoch ist auch aus einem Aufsatz von P. S. Murarka und D. B. Fraser aus dem J. Appl. Phys., 51 (1980), Seiten 1593 bis 1598, insbesondere Seite 1594, zu entnehmen, daß diese Materialien gegenüber dem stöchiometrischen Dizilizid einen erhöhten spezifischen elektrischen Widerstand besitzen.

Die Verwendung der reinen Metalle Molybdän und Wolfram stößt insofern auf Schweirigkeiten, als beide Metalle keine Passivierungsschicht bilden und in sauerstoffhaltiger Atmosphäre sogar flüchtige Oxide entstehen können. Es müssen deshalb zusätzliche Fertigungsschritte wie zum Beispiel Tempern in feuchter Wasserstoffatmosphäre oder Abdecken des Metalles mit Oxiden eingeführt werden. Eine zusätzliche Schwierigkeit bei der Kombination Molybdän bzw. Wolfram mit $SiO_2$ besteht darin, daß aufgrund der geringen chemischen Affinität zwischen den Materialien die Haftung dieser Metalle auf dem Gateoxid mangelhaft ist. Eine Lösung dieses Problems könnte darin bestehen, eine dünnen (zum Beispiel 50 nm) Zwischenschicht aus siliziumreichem Wolframdisilizid bzw. Molybdändisilizid zu verwenden oder eine Molybdän-Tantal-Legierung mit ca. 8 Mol.% Tantal als Schicht zwischen dem $SiO_2$-Gate und dem reinem Molybdän einzusetzen. Für MOS-Fertigungslinien, in denen bislang die Kombination Tantaldilizid/Poly-Si als Gatemetallisierung oder Tantalsilizid (35 mol% Tantal) als Diffusionsbarriere zwischen Silizium und Aluminium verwendet wurde, würde es eine gravierende Umstellung bzw. einen großen apparativen Aufwand bedeuten, für eine niederohmige Gatemetallisierung ein zusätzliches Material, zum Beispiel Molybdän oder Wolfram, einzuführen. Ein entsprechendes Gatematerial auf Tantal-Basis, welches für diese Fertigungslinien von größtem wirtschaftlichem Interesse wäre, ist bisher nicht bekannt.

Die vorliegende Erfindung soll hier Abhilfe schaffen und eine Gatemetallisierung für eine MOS-Transistoren enthaltende integrierte Schaltung angeben, die sowohl einen niedrigen Flächenwiderstand und eine hohe Austrittsarbeit, als auch eine hohe Temperaturstabilität besitzt.

Die Erfindung erreicht dieses Ziel durch die im kennzeichnenden Teil des Anspruchs 1 aufgeführten Merkmale.

Weitere Ausgestaltungen der Erfindung, insbesondere ein Verfahren zur Herstellung der Gatemetallisierung, ergeben sich aus den Unteransprüchen.

Folgende Untersuchungen haben zu der Erfindung geführt: Die Reaktion

$$2\ Ta + 2.5\ SiO_2 \rightarrow Ta_2O_5 + 2.5\ Si,$$

welche die Zerstörung des Gateoxids ($SiO_2$) durch Tantal qualitativ beschreibt, kann dadurch zu Temperaturen über 950°C verschoben werden, daß das Tantal bereits bei der Abscheidung auf $SiO_2$ mit Sauerstoff dotiert wird. Es hat sich gezeigt, daß die Dotierung von Tantal bzw. einer Tantal-Silizium (33 bis 40 Mol% Tantal)-Legierungsschicht mit Sauerstoff nur in einem dünnen Schichtbereich (typisch 5 bis 100 nm) zu Beginn der Beschichtung erfolgen muß. Bei den nachträglichen Hochtemperatur-Fertigungsschritten, bei zum Beispiel 900°C, werden nur ca. 2 bis 4 nm des Gateoxides verbraucht. Die Grenzfläche weist dabei nur eine sehr geringe Welligkeit von ca. 1 nm auf. Die Tatsache, daß eine geringfügige Reaktion zwischen dem mit Sauerstoff dotierten Tantal bzw. Tantalsilizid auftritt, bestätigt die gute Haftung des Materials auf dem Gateoxid. Die Durchbruchsspannungen sind identisch mit den Poly-Si-Gates.

Um auch mit der sauerstoffdotierten Tantalsilizid-Schicht den geforderten Widerstand zu erreichen, sollte die Gesamtdicke dieser Legierungsschicht nur zum Beispiel 80 nm betragen. Darauf wird dann eine zum Beispiel 400 nm dicke Tantalschicht aufgebracht, die nach der 900°C Temperung einen spezifischen elektrischen Widerstand von ca. 15 µOhm cm besitzt.

Die Sauerstoffkonzentration in der dotierten Zone ist derart zu wählen, daß nach der Herstellung das Tantal bzw. der Tantalanteil im Tantalsilizid als amorphes Suboxid, zum Beispiel TaO, vorliegt. Dabei wird die Sauerstoffkonzentration auf 10 bis 30 Mol% eingestellt.

Bei einer nachträglichen Temperaturbehandlung (zum Beispiel 900°C in einer Stunde) kristallisiert das amorphe Oxid und es kann eine sehr dünne $Ta_2O_5$-haltige Zone beobachtet werden. Im Falle der Tantalsilizid-Zwischenschicht kann zusätzlich noch $SiO_2$ entstehen. Ein wesentliches Kriterium für die richtige Sauerstoffdotierung ist auch, daß die höhere Austrittsarbeit von Tantal bzw. Tantalsilizid im Vergleich zu Poly-Si erhalten bleibt.

Im folgenden wird anhand von zwei Ausführungsbeispielen und der in der Zeichnung befindlichen Figuren 1 bis 3 die Erfindung noch näher erläutert. Dabei zeigen

die Figur 1 in schematischer Darstellung den Aufbau einer Anlage zum Co-Sputtern mit zwei Targets, wie sie zur Herstellung der Gatemetallisierung mit Vorteil verwendet wird und

die Figuren 2 und 3 den Schichtaufbau zweier, nach dem erfindungsgemäßen Verfahren hergestellten Anordnungen im Schnittbild.

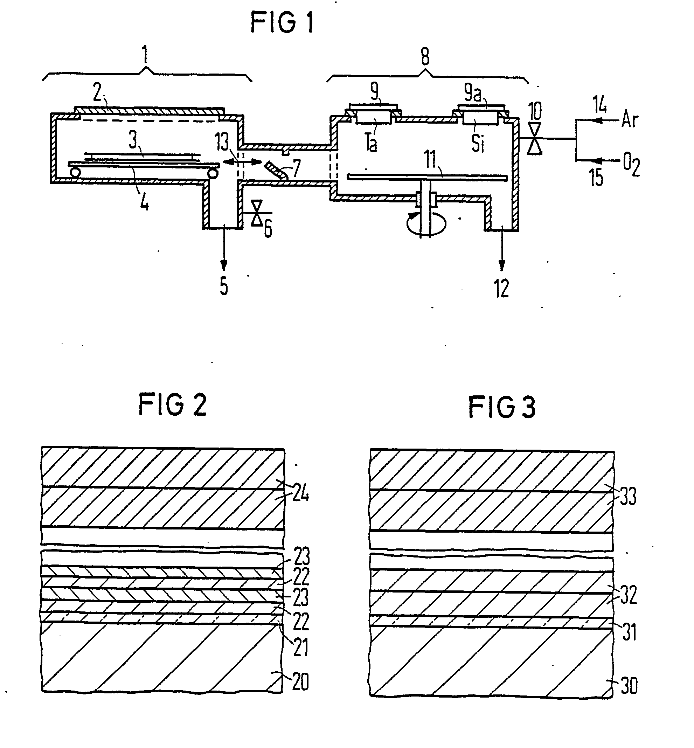

Figur 1: Es wird die Herstellung eines niederohmigen Gatematerials auf Tantalbasis näher beschrieben. Für den Schichtaufbau (Figur 2) wird eine mit Sauerstoff dotierte Tantal-Silizium (35 Mol% Tantal)-Zwischenschicht mit einer Schichtdicke von ca. 80 nm verwendet, auf die eine ca. 400 nm dicke reine Tantalschicht als Deckschicht aufgebracht wird.

Mit der in der Figur 1 dargestellten Co-Sputter-Anlage ist es möglich, reines Silizium und reines Tantal gleichzeitig zu zerstäuben. Die Co-Sputter-Anlage (Perkin-Elmer 4400) wird dafür so gestaltet, daß die zu beschichtenden Siliziumsubstrate auf dem Drehteller 11 wiederholt am Tantal- und Silzium-Target (9, 9a) vorbeigeführt werden, so, daß eine mehrlagige Schicht aus Tantal und Silizium abgeschieden wird. Nähere Einzelheiten sind dem Bericht von H. Oppolzer et al. im J. Vac. Sci. Technol, B 2 (4) 1984, auf den Seiten 630 bis 635 zu entnehmen. Die Dicke der Lagen ist sehr gering (zum Beispiel 1 bis 10 nm), so daß bereits bei der Herstellung eine gewisse Durchmischung von beiden Materialien erfolgt. Die Zusammensetzung des Tantal-Silizium-Schichtpaketes wird durch das Verhältnis der Dicken der Einzellagen bestimmt. Im Falle einer Zusammensetzung von 35 Mol% Tantal ist das Schichtdickenverhältnis Silizium/Tantal ca. 2.

Zum Be- und Entladen der Substratpalette 3 mit Substraten (die Substrate sind in der Figur nicht dargestellt) wird der Schleusendeckel 2 der Hochvakuumschleuse 1 geöffnet. Das Zwischenventil 7 ist geschlossen. Im Sputterrezipienten 8 ist weiterhin Hochvakuum (ungefähr $10^{-6}$ mbar). Über ein Schlittensystem 4 wird die Palette 3 in den Beschichtungsraum 8 (siehe Doppelpfeil 13) transportiert, wenn in der Schleuse 1 ähnliche Druckverhältnisse herrschen wie im Beschichtungsraum 8. Dort wird die Palette 3 auf einem Drehtisch 1 abgelegt. Der Transportschlitten 4 fährt in die Schleuse 1 zurück und die Zwischentüre 7 wird wieder geschlossen. Während der Beschichtung wird die Palette mit Hilfe des Drehtellers 11 gedreht. Die Pfeile 5 und 12 deuten den Anschluß der Hochvakuumpumpen an. Mit den Bezugszeichen 9 und 9a sind die Sputtertargets aus Tantal und Silizium bezeichnet, mit 10 das Argoneinlaßventil und mit 6 das Belüftungsventil; 14 und 15 deuten Durchflußmesser für Argon und Sauerstoff an.

Nachdem die Substrate 9, 9a über die Hochvakuumschleuse 1 in die eigentliche Beschichtungskammer 8 eingeführt worden sind, wird eine definierte Menge Sauerstoff über den Durchflußmesser 15 in die Anlage 8 einglassen. Im Beispiel sind dies 0,5 ml (bei Normaldruck). Zusätzlich zum Sauerstoff wird dann das eigentliche Sputtergas Argon beigemischt (zum Beispiel 14 ml). Die Absolutmengen für die Gase (14, 15) hängen von mehreren apparativen Parametern, wie zum Beispiel Abstand Target-Substrat, Strömungsbedingungen im Sputterrezipienten, saugleistung der Pumpen und Aufwachsrate der Materialien, ab. Das Volumenverhältnis Argon/Sauerstoff wird im Bereich von 5 bis 30 eingestellt.

Haben sich konstante Strömungsbedingungen eingestellt, so wird das Tantaltarget 9 gezündet und gleichzeitig beginnen die Substrate sich am Tantaltarget 9 vorbeizubewegen. Sind alle Substrate mit einer ca. 1 nm dicken Tantallage belegt, so wird zusätzlich das Siliziumtarget 9a gezündet. Die Dicke der pro Umdrehung abgeschiedenen Siliziumlagen liegt bei ca. 2 nm. Nachdem zum Beispiel 26 Tantal-Silizium-Doppellagen von jeweils 3 nm Dicke abgeschieden sind, wird die Sauerstoffzufuhr 10 unterbrochen und auf die Silizium-Abscheidung (9a) beendet. Mann kann nun die Aufwachsrate für Tantal (zum Beispiel 20 nm/Lage) erhöhen, um möglichst schnell die restlichen 400 nm Tantal der Deckschicht abzuscheiden.

Nach einer Temperung der Substrate in einer eigens dafür vorgesehenen Rohrofenanlage bei zum Beispiel 900°C in Argon (ca. 1 Stunde) sinkt der Widerstand der aufgestäubten Schichtpakete auf seinen endgültigen Wert ab. Die sauerstoffdotierte ca. 80 nm dicke Tantalsilizid-Schicht besitzt nun einen spezifischen elektrischen Widerstand von ca. 150 µOhm cm, während der spezifische elektrische Widerstand der Tantal-Schicht bei ca. 15 µOhm cm liegt. Daraus ergibt sich ein Flächenwiderstand für die Tantalsilizid/Tantal-Gatemetallisierung von 0,35 bis 0,40 Ohm/□.

In Figur 2 ist der lagenweise Aufbau der in Figur 1 hergestellten Schichtenfolge dargestellt. Dabei ist mit dem Bezugszeichen 20 das Siliziumsubstrat, mit 21 das Gate-oxid (20 nm), mit 22 die 1 nm dicken Tantal-Lagen mit Sauerstoff dotiert, mit 23 mit 2 nm dicken Siliziumlagen mit Sauerstoff dotiert und mit 24 die 400 nm dicke reine Tantalschicht (ohne Sauerstoffdotierung) bezeichnet.

Figur 3 Wird nur Tantal (Target 9) als Gatemetall benutzt, so wird für die Sauerstoffdotierung eine etwas höhere Konzentration im Argon gewählt. Das Volumenverhältnis Argon/Sauerstoff liegt im Bereich zwischen 2 und 20. Auch in diesem Fall wird die Sauerstoffdotierung zu Beginn der Beschichtung vorgenommen. Die Dicke des dotieren Bereiches liegt typisch zwischen 5 und 100 nm. In der Figur ist mit 30 das Siliziumsubstrat, mit 31 das 20 nm dicke Gateoxid ($SiO_2$), mit 32 die 3 nm dicken, mit Sauerstoff dotierten Tantal-Lagen und mit 33 die 20 nm dicken Tantal-Lagen ohne Sauerstoffdotierung bezeichnet.

Mit dieser Metallisierung können nach der Temperung (900°C, Argon, 1 Stunde) Minimalwerte des Flächenwiderstandes von 0,3 erreicht werden.

Im Gegensatz zu der im US-Patent 4.337.476 beschriebenen Gatemetallisierung kann auch eine Tantal- bzw. eine Tantalsilizid-Zwischenschicht mit leichtem Tantal-Überschuß (35 Mol% Tantal) verwendet werden. Neben dem Vorteil, daß für das Tantal-Silizium-Gate und die Tantal-Silizium-Diffusionbarriere in Kontakten dasselbe Ausgangsmaterial verwendet werden kann, hat die erfindungsgemäße Materialkombination den Vorteil des geringeren spezifischen elektrischen Widerstandes und der höheren Austrittsarbeit im Vergleich zu Poly-Si bzw. Si-reichen Disiliziden.

Aufgrund der Ähnlichkeit der Elemente Niob und Tantal kann auch mit einer sauerstoffdotierten Niob- bzw. Niob-Silizium-Zwischenschicht und einer 400 nm dicken, reinen Niob-Deckschicht eine niederohmige Gatemetallisierung hergestellt werden.

**Patentansprüche**

1. Integrierte MOS-Transistoren enthaltende Schaltungen mit einem aus Silizium bestehenden Halbleitersubstrat, in dem und auf dem die die Schaltung bildenden Elemente wie Source-/Drainzonen, Gateelektroden und Kontakleitbahnen, von Isolationsschichten getrennt, in MOS-Technik erzeugt sind und bei der die über dem Gateoxid aufgebrachte Gatemetallisierung aus Tantal, Niob oder einem Metallsilizid eines dieser Elemente besteht, dadurch gekennzeichnet, daß die Gatemetallisierung (22, 23, 24, 32, 33) an der an das Gateoxid (21, 31) angrenzenden Oberfläche eine mit Sauerstoff dotierte Metall (32) oder Metallsilizid-Zwischenschicht (22, 23) eines der besagten Elemente enthält, deren Dicke 1/20 bis 1/5 der Schichtdicke der Gatemetallisierung beträgt und daß die Zwischenschicht (22, 23) aus reinem Metallsuboxid oder aus Metallsilizid, dessen Metallgehalt zu Suboxid umgewandelt ist, eines der besagten Elemente besteht.

2. Integrierte MOS-Schaltung nach Anspruch 1, dadurch gekennzeichnet, daß die Dicke der dotierten Zwischenschicht (22, 23, 32) im Bereich von 5 bis 100 nm liegt.

3. Integrierte MOS-Schaltung nach Anspruch 1 und 2, gekennzeichnet durch eine Gatemetallisierung, bestehend aus einer 70 bis 90 nm dicken, sauerstoffdotierten Tantalsilizidzwischenschicht (22, 23) und einer 400 bis 500 nm dicken Tantalschicht (24).

4. Integrierte MOS-Schaltung nach mindestens einem der Ansprüche 1 bis 3, dadurch gekennzeichnet, daß die Zwischenschicht (22, 23, 32) aus reinem Tantalsuboxid oder aus Tantalsilizid, dessen Tantalgehalt zu Suboxid umgewandelt ist, besteht.

5. Integrierte MOS-Schaltung nach mindestens einem der Ansprüche 1 bis 4, dadurch gekennzeichnet, daß die Gatemetallisierung (22, 23, 24, 32, 33) durch Hochfrequenz-Kathodenzerstäubung (Sputtern) hergestellt ist.

6. Verfahren zum Herstellen der Gatemetallisierung einer integrierten MOS-Schaltung nach mindestens einem der Ansprüche 1 bis 5, dadurch gekennzeichnet, daß die Gateoxide der Substrate in einer Hochfrequenz-Kathodenzerstäuberungsanlage (1, 8) (HF-Sputteranlage), in welcher sich ein Tantal- bzw. Tantal- und Silizium-Targets (9, 9a) befinden, lagenweise mit Tantal bzw. mit Tantal und Silizium in sauerstoffhaltiger Atmosphäre (15) unter Verwendung von Argon (14) als Sputtergas solange bestäubt werden, bis die Schichtdicke der Tantal- bzw. Tantalsilizidzwischenschicht erreicht ist und dann die Zerstäubung nach Abschaltung der Sauerstoffzufuhr bzw. des Siliziumtargets (9a) und der Sauerstoffzufuhr (15) mit Tantal (9) allein fortgesetzt wird und daß nach der Abscheidung der Oberschicht (24, 33) eine Temperung des Substrats bei Temperaturen unter 950°C erfolgt.

7. Verfahren nach Anspruch 6, dadurch gekennzeichnet, daß die Dicke der Lagen (22, 23, 32) der Zwischenschicht auf 1 bis 10 nm eingestellt wird.

8. Verfahren nach Anspruch 6 und 7, dadurch gekennzeichnet, daß das Volumenverhältnis Argon/Sauerstoff auf einen Bereich von 5 bis 30 eingestellt wird.

9. Verfahren nach mindestens einem der Ansprüche 6 bis 8, dadurch gekennzeichnet, daß das Verhältnis von Tantal (22) zu Silizium (23) bei der Zwischenschichtabscheidung bezüglich der Einzellagendicke so eingestellt wird, daß ein sauerstoffdotiertes Tantalsilizid mit 35 Mol% Tantal entsteht.

10. Verfahren nach mindestens einem der Ansprüche 6 bis 9, dadurch gekennzeichnet, daß bei der Herstellung einer aus mit Sauerstoff dotiertem Tantalsilizid bestehenden Zwischenschicht (22, 23) mit einer 1 nm dicken Tantallage (22) begonnen wird, darauf eine 2 nm dicke Siliziumlage (23) aufgebracht wird und die Beschichtung im gleichen Rhythmus in Sauerstoffatmosphäre fortgesetzt wird, bis 26 Doppel-Lagen (22, 23) Tantal/Silizium erreicht sind (Figur 2).

11. Verfahren nach mindestens einem der Ansprüche 6 bis 10, dadurch gekennzeichnet, daß bei der Herstellung einer mit sauerstoffdotierten Tantalzwischenschicht (32) das Volumenverhältnis Argon/Sauerstoff im Bereich zwischen 2 und 20 gewählt wird (Figur 3).

12. Verfahren nach mindestens einem der Ansprüche 6 bis 11, dadurch gekennzeichnet, daß die reine Tantalabscheidung (24, 33) in 20 nm dicken Lagen weitergeführt wird (Figuren 2 und 3).

13. Verfahren nach mindestens einem der Ansprüche 6 bis 12, dadurch gekennzeichnet, daß die Substrate im Anschluß an die Gatemetallisierung einer Hochtemperaturbehandlung bei ca. 900°C in Argonatmosphäre unterzogen werden.

14. Verfahren nach mindestens einem der Ansprüche 6 bis 13, dadurch gekennzeichnet, daß die Temperaturbehandlungsdauer auf 1 Stunde eingestellt wird.

**Revendications**

1. Circuit intégré comportant des transistors MOS, avec un substrat constitué par du silicium, dans lequel et sur lequel sont produits en technique MOS et avec séparation par des couches isolantes, les éléments tels que les zones source/drain, les électrodes de grille et les pistes conductrices de contact qui forment le circuit, et dans lequel la métallisation de grille déposée sur l'oxyde de grille est constituée par du tantale, par du niobium ou par un siliciure métallique de l'un de ces éléments, caractérisé par le fait que la métallisation de grille (22, 23, 24, 32, 33) comporte au niveau de la surface qui jouxte l'oxyde de grille (21, 31) une couche intermédiaire (22, 23) d'un métal (32) dopé en oxygène ou d'un siliciure métallique d'un des éléments sus-mentionnés, et dont l'épaisseur est égale à 1/20 à 1/5 de l'épaisseur de la couche de métallisation de grille, et que la couche intermédiaire (22, 23) est constituée par un oxyde métallique pur ou par un siliciure métallique dont la teneur en métal est transformée en hypoxyde, de l'un des éléments susmentionnés.

2. Circuit MOS intégré selon la revendication 1, caractérisé par le fait que l'épaisseur de la couche intermédiaire dopée (22, 23, 32) se situe dans la plage de 5 à 100 nm.

3. Circuit MOS intégré selon les revendications 1 et 2, caractérisé par une métallisation de grille constituée par une couche intermédiaire (22, 23) dopée en oxygène et d'une épaisseur de 70 à 90 nm, et par une couche de tantale (24) ayant une épaisseur de 400 à 500 nm.

4. Circuit MOS intégré selon au moins l'une des revendications 1 à 3, caractérisé par le fait que la couche intermédiaire (22, 23, 32) est constituée par de l'hypoxyde pur de tantale ou par du siliciure de tantale, dont la teneur en tantale a été transformée en hypoxyde.

5. Circuit MOS intégré selon au moins l'une des revendications 1 à 4, caractérisé par le fait que la métallisation de grille (22, 23, 24, 32, 33) est produite par pulvérisation cathodique haute fréquence.

6. Procédé pour réaliser la métallisation de grille d'un circuit MOS intégré, selon au moins l'une des revendications 1 à 5, caractérisé par le fait que les oxydes de grille des substrats sont soumis, dans une installation à pulvérisation cathodique haute fréquence (1, 8) dans laquelle se trouve une cible en tantale ou des cibles en tantale et en silicium (9, 9a), par couches successives, à des pulvérisations au tantale ou au tantale et au silicium dans une atmosphère à teneur d'oxygène (15), avec mise en oeuvre d'argon (14) comme gaz de pulvérisation cathodique, jusqu'à ce que l'épaisseur de la couche intermédiaire de tantale ou de siliciure de tantale soit obtenue et qu'ensuite, après coupure de l'alimentation en oxygène ou de la cible en silicium (9a) et de l'alimentation en oxygène (15), la pulvérisation au tantale (9) seule est poursuivie, et qu'après le dépôt de la couche supérieure (24, 33) on procède à un traitement thermique du substrat à des températures inférieures à 950°C.

7. Procédé selon la revendication 6, caractérisé par le fait que l'épaisseur des couches (22, 23, 32) de la couche intermédiaire est réglée à une valeur de 1 à 10 nm.

8. Procédé selon les revendications 6 et 7, caractérisé par le fait que le rapport volumique argon/oxygène est réglé à une plage de 5 à 30.

9. Procédé selon au moins l'une des revendications 6 à 8, caractérisé par le fait que le rapport entre le tantale (22) et le silicium (23) est ajusté, lors du dépôt de la couche intermédiaire et pour ce qui concerne l'épaisseur de couches individuelles, de façon qu'il se forme un siliciure de tantale à dopage en oxygène à 35% mole de tantale.

10. Procédé selon l'une au moins des revendications 6 à 9, caractérisé par le fait que lors de la réalisation d'une couche intermédiaire (22, 23) constitué par du siliciure de tantale à dopage à l'oxygène, on commence avec une couche de tantale (22) d'une épaisseur de 1 nm, qu'on y dépose une couche de silicium (23) d'une épaisseur de 2 nm, et que l'on poursuit au même rythme la réalisation du revêtement dans une atmosphère d'oxygène jusqu'à l'obtention de 26 couches doubles (22, 23) de tantale/silicium (figure 2).

11. Procédé selon au moins l'une des revendications 6 à 10, caractérisé par le fait que lors de la réalisation d'une couche intermédiaire au tantale (32), dopé en oxygène, on choisit le taux des volumes argon/oxygène dans une plage située en 2 et 20 (figure 3).

12. Procédé selon au moins l'une des revendications 6 à 11, caractérisé par le fait que le dépôt pur de tantale (24, 33) est poursuivi avec des couches de 20 nm d'épaisseur (figures 2 et 3).

13. Procédé selon au moins l'une des revendications 6 à 12, caractérisé par le fait que les substrats sont soumis, après la métallisation de la grille, à un traitement thermique à température élevée, à environ 900°C dans une atmosphère d'argon.

14. Procédé selon au moins l'une des revendications 6 à 13, caractérisé par le fait que la durée du traitement thermique est réglée à 1 heure.

**Claims**

1. Integrated circuits containing MOS transistors, having a semiconductor substrate made of silicon, in which and on which the elements forming the circuit such as source/drain regions, gate electrodes and contact interconnects are produced, separated by insulating layers, in MOS technology, and in which the gate metallization applied over the gate oxide is made of tantalum, niobium or a metal silicide of one of these elements, characterized in that, at the surface bordering the gate oxide (21, 31), the gate metallization (22, 23, 24, 32, 33) contains an oxygen-doped metal (32) or intermediate metal silicide layer (22, 23) of one of said elements, the thickness of which is 1/20 to 1/5 of the layer thickness of the gate metallization, and in that the intermediate layer (22, 23) is made of pure metal suboxide, or of metal silicide whose metal content has been converted to suboxide, of one of said elements.

2. Integrated MOS circuit according to Claim 1, characterized in that the thickness of the doped intermediate layer (22, 23, 32) lies in the range of 5 to 100 nm.

3. Integrated MOS circuit according to Claim 1 and 2, characterized by a gate metallization consisting of a 70 to 90 nm thick, oxygen-doped intermediate tantalum silicide layer (22, 23) and a 400 to 500 nm thick tantalum layer (24).

4. Integrated MOS circuit according to at least one of Claims 1 to 3, characterized in that the intermediate layer (22, 23, 32) is made of pure tantalum suboxide or of tantalum silicide whose tantalum content has been converted to suboxide.

5. Integrated MOS circuit according to at least one of Claims 1 to 4, characterized in that the gate metallization (22, 23, 24, 32, 33) is produced by high-frequency cathode sputtering.

6. Method for producing the gate metallization of an integrated MOS circuit according to at least one of Claims 1 to 5, characterized in that the gate oxides of the substrates are sputtered layer by layer with tantalum or with tantalum and silicon in oxygen-containing atmosphere (15) using argon (14) as sputtering gas in a high-frequency cathode sputtering device (1, 8) (HF sputtering device) in which there is a tantalum or bantalum and silicon targets (9, 9a), until the layer thickness of the tantalum layer or intermediate tantalum silicide layer is reached, and then the sputtering is continued solely with tantalum (9) after switching off the oxygen supply or the silicon target (9a) and the oxygen supply (15), and in that the substrate is annealed after the deposition of the top layer (24, 33) at temperatures under 950°C.

7. Method according to Claim 6, characterized in that the thickness of the layers (22, 23, 32) of the intermediate layer is set to 1 to 10 nm.

8. Method according to Claim 6 and 7, characterized in that the volume ratio of argon to oxygen is set to a range of 5 to 30.

9. Method according to at least one of Claims 6 to 8, characterized in that the ratio of tantalum (22) to silicon (23) is set during the deposition of the intermediate layer in such a way with respect to the individual layer thickness that an oxygen-doped tantalum silicide with 35 mol% tantalum is obtained.

10. Method according to at least one of Claims 6 to 9, characterized in that in the case of the production of an intermediate layer (22, 23) made of oxygen-doped tantalum silicide, first a 1 nm thick tantalum layer (22) is produced, a 2 nm thick silicon layer (23) is applied to this and the coating is continued in the same rhythm in oxygen atmosphere until 26 double-layers (22, 23) of tantalum/silicon are obtained (Figure 2).

11. Method according to at least one of Claims 6 to 10, characterized in that during the production of an oxygen-doped intermediate tantalum layer (32), the volume ratio of argon to oxygen is selected to be in the range between 2 and 20 (Figure 3).

12. Method according to at least one of Claims 6 to 11, characterized in that the pure tantalum deposition (24, 33) is continued in 20 nm thick layers (Figures 2 and 3).

13. Method according to at least one of Claims 6 to 12, characterized in that, after the gate metallization, the substrates are subjected to a high-temperature treatment at approximately 900°C in argon atmosphere.

14. Method according to at least one of Claims 6 to 13, characterized in that the temperature treatment duration is set to 1 hour.

EP 0 207 486 B1

FIG 1

FIG 2

FIG 3

1